(19) Europäisches Patentamt / European Patent Office / Office européen des brevets

(11) **EP 4 300 732 B1**

(12) **EUROPEAN PATENT SPECIFICATION**

(45) Date of publication and mention
of the grant of the patent:
**23.07.2025 Bulletin 2025/30**

(21) Application number: **22759757.2**

(22) Date of filing: **24.02.2022**

(51) International Patent Classification (IPC):
$H01S\ 5/18^{(2021.01)}$    $H01S\ 5/11^{(2021.01)}$
$H01S\ 5/20^{(2006.01)}$    $H01S\ 5/343^{(2006.01)}$
$H01S\ 5/185^{(2021.01)}$    $H01S\ 5/042^{(2006.01)}$

(52) Cooperative Patent Classification (CPC):
**H01S 5/04254; H01S 5/11; H01S 5/185;**
H01S 5/04256; H01S 5/2027; H01S 5/34313;
H01S 2301/163

(86) International application number:
**PCT/JP2022/007739**

(87) International publication number:
**WO 2022/181722 (01.09.2022 Gazette 2022/35)**

(54) **TWO-DIMENSIONAL PHOTONIC-CRYSTAL SURFACE-EMITTING LASER**

OBERFLÄCHENEMITTIERENDER LASER MIT ZWEIDIMENSIONALEM PHOTONISCHEM KRISTALL

LASER À ÉMISSION PAR LA SURFACE À CRISTAL PHOTONIQUE BIDIMENSIONNEL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.02.2021 JP 2021027908**

(43) Date of publication of application:
**03.01.2024 Bulletin 2024/01**

(73) Proprietor: **Kyoto University**
**Kyoto-shi, Kyoto 606-8501 (JP)**

(72) Inventors:
• **NODA, Susumu**
**Kyoto-shi, Kyoto 606-8501 (JP)**
• **INOUE, Takuya**
**Kyoto-shi, Kyoto 606-8501 (JP)**
• **YOSHIDA, Masahiro**
**Kyoto-shi, Kyoto 606-8501 (JP)**
• **ISHIZAKI, Kenji**
**Kyoto-shi, Kyoto 606-8501 (JP)**

(74) Representative: **Hoeger, Stellrecht & Partner**
**Patentanwälte mbB**
**Uhlandstrasse 14c**
**70182 Stuttgart (DE)**

(56) References cited:
WO-A1-2016/031965    WO-A1-2020/170805
JP-A- 2012 227 425    JP-A- 2019 106 397
US-A1- 2014 211 822    US-A1- 2016 020 581
US-A1- 2019 013 647    US-A1- 2019 067 907

EP 4 300 732 B1

**Description**

TECHNICAL FIELD

The present invention relates to a two-dimensional photonic-crystal surface-emitting laser in which a two-dimensional photonic crystal is used for amplifying light.

BACKGROUND ART

Semiconductor lasers have many advantages such as small size, low cost, low power consumption, and long life, and are widely used in a wide range of fields such as light sources for optical recording, light sources for communication, laser displays, laser printers, and laser pointers. In the field of laser machining, a laser having a light output of at least more than 100 W and a narrow beam divergence angle is required, but currently used semiconductor laser has not reached this output. Therefore, in the field of laser machining, a gas laser such as a carbon dioxide laser is widely used instead of a semiconductor laser.

In recent years, a two-dimensional photonic-crystal surface-emitting laser has attracted attention as a semiconductor laser expected to obtain a high light output while maintaining a narrow beam divergence angle. The two-dimensional photonic-crystal surface-emitting laser has a two-dimensional photonic-crystal layer in which modified refractive index regions having a refractive index different from that of a plate-like base material are periodically disposed, and an active layer that serves as a light emitting layer. The modified refractive index region is typically made of a hole formed in the base material. In the two-dimensional photonic-crystal surface-emitting laser, only light having a predetermined wavelength corresponding to the period of the modified refractive index regions among light generated in the active layer by supplying an electric current into the active layer is amplified and laser-oscillated, and emitted as a laser beam in a direction perpendicular to the two-dimensional photonic-crystal layer. The two-dimensional photonic-crystal surface-emitting laser emits light (surface emission) from within a certain range in the two-dimensional photonic-crystal layer, and therefore the two-dimensional photonic-crystal surface-emitting laser has an emission area larger than that of a conventional end surface emitting type semiconductor laser, and has an advantage of easily increasing light output.

Patent Literature 1 describes a two-dimensional photonic-crystal surface-emitting laser including a two-dimensional photonic-crystal layer in which modified refractive index region pairs formed by disposing two modified refractive index regions having different planar areas (planar areal amounts) apart from each other by a predetermined distance in a plate-like base material are periodically arranged on a square lattice with a period length $a$ longer than the predetermined distance. Hereinafter, among the two modified refractive index regions constituting the modified refractive index region pair, the region having a larger planar area is referred to as "main modified refractive index region", and the region having a smaller planar area is referred to as "sub-modified refractive index region". In addition, one of the two directions orthogonal to each other in which lattice points are disposed with the period length $a$ in a square lattice on which the modified refractive index region pairs are arranged is referred to as "x direction", and the other is referred to as "y direction".

In the configuration of Patent Literature 1, in a case where both the distance (denoted as $d_x$) in the x direction and the distance (denoted as $d_y$) in the y direction from the main modified refractive index region, of the sub-modified refractive index region are 0.25$a$, out of light having a wavelength (depending on the refractive index in the two-dimensional photonic-crystal layer) $\lambda$ in the two-dimensional photonic-crystal layer, light reflected by the main modified refractive index region and changing in the traveling direction by 180° and light reflected by the sub-modified refractive index region and changing in the traveling direction by 180° have a difference in optical path length of 0.5$\lambda$, and are weakened by interference. The reflection of the light in the 180° direction causes the light to be localized in a partial region in the two-dimensional photonic-crystal layer due to the repetition of the reflection, and in addition to the oscillation of the fundamental mode by the light having the wavelength $\lambda$, a higher order mode having an oscillation wavelength and a spatial light distribution different from those of the fundamental mode is also simultaneously oscillated, which causes an increase in the beam divergence angle. Therefore, with the above configuration, light can be localized in a partial region in the two-dimensional photonic-crystal layer, and single mode oscillation in the fundamental mode can be maintained even if the area of the two-dimensional photonic-crystal layer is increased to some extent (for example, the radius of the inscribed circle in the range in which the modified refractive index region is disposed is 300 $\mu$m to 500 $\mu$m).

CITATION LIST

PATENT LITERATURE

Patent Literature 1: JP 2008-243962 A

Reference is also made to the following documents:

US 2019/067907 A1 (NODA SUSUMU) 28 February 2019;
WO 2016/031965 A1 (UNIV KYOTO) 3 March 2016;
US 2019/013647 A1 (HIGUCHI AKIRA) 10 January 2019;
US 2016/020581 A1 (HIROSE KAZUYOSHI) 21 January 2016.

## SUMMARY OF INVENTION

### TECHNICAL PROBLEM

In the two-dimensional photonic-crystal surface-emitting laser described in Patent Literature 1, as described above, the effect of reflecting light in the 180° direction by the modified refractive index regions is weakened, so that oscillation in a single mode (single wavelength) including the fundamental mode can be maintained even if the area of the two-dimensional photonic-crystal layer is enlarged to some extent. However, in the two-dimensional photonic-crystal layer, diffraction (90° diffraction) in which the traveling direction of light changes by 90° due to the periodically disposed modified refractive index regions and diffraction (emission light) in a direction perpendicular to the two-dimensional photonic-crystal layer also occur. When the area of the two-dimensional photonic-crystal layer is further increased, light is localized in a partial region in the two-dimensional photonic crystal also due to these types of diffraction. As a result, oscillation in higher order modes (shorter wavelengths) are likely to occur, and the beam angle expands accordingly.

The invention is defined in independent claim 1. Preferred embodiments are given in the dependent claims.

An object of the present invention is to provide a two-dimensional photonic-crystal surface-emitting laser capable of achieving oscillation of laser light of a single wavelength.

### SOLUTION TO PROBLEM

A two-dimensional photonic-crystal surface-emitting laser according to the present invention made to solve the above problems includes:

    a) a two-dimensional photonic-crystal layer in which modified refractive index regions having a refractive index different from a refractive index of a plate-like base material are periodically disposed in the base material;
    b) an active layer provided on one surface side of the two-dimensional photonic-crystal layer; and
    c) a reflection layer provided on another surface side of the two-dimensional photonic-crystal layer or on a side of the active layer opposite to the two-dimensional photonic-crystal layer so as to be separated from the two-dimensional photonic-crystal layer,

wherein a distance between surfaces of the two-dimensional photonic-crystal layer and the reflection layer facing each other is set such that a radiation coefficient difference $\Delta\alpha_v = (\alpha_{v1} - \alpha_{v0})$, which is a value obtained by subtracting a radiation coefficient $\alpha_{v0}$ of a fundamental mode having a smallest loss from a radiation coefficient $\alpha_{v1}$ of a first higher order mode having a second smallest loss among light amplified in the two-dimensional photonic-crystal layer, is 1 cm$^{-1}$ or more.

Herein, the radiation coefficient refers to a ratio of light, among light existing as a waveguide mode in the two-dimensional photonic-crystal layer, radiated in a direction perpendicular to the two-dimensional photonic-crystal layer by diffraction while the light is guided in a unit length.

In the two-dimensional photonic-crystal surface-emitting laser, an interaction between light (in-plane guided light) guided in the two-dimensional photonic-crystal layer and emission light emitted from the two-dimensional photonic-crystal layer in a direction perpendicular to the two-dimensional photonic-crystal layer affects the values of the radiation coefficients $\alpha_{v0}$ and $\alpha_{v1}$ of the fundamental mode and the first higher order mode. When a reflection layer is provided apart from the two-dimensional photonic-crystal layer, light (referred to as "first emission light") emitted from the two-dimensional photonic-crystal layer to the opposite side of the reflection layer and light (referred to as "second emission light") emitted from the two-dimensional photonic-crystal layer to the reflection layer side and reflected by the reflection layer interfere with each other to generate the emission light, so that the magnitude of interaction between the in-plane guided light and the emission light can be set according to the distance (inter-plane distance) between the surfaces facing each other of the two-dimensional photonic-crystal layer and the reflection layer. Therefore, the values of the radiation coefficient $\alpha_{v0}$ of the fundamental mode and the radiation coefficient $\alpha_{v1}$ of the first higher order mode can be set by the magnitude of the inter-plane distance, whereby the value of the radiation coefficient difference $\Delta\alpha_v = (\alpha_{v1} - \alpha_{v0})$ can also be set.

By making the radiation coefficient difference $\Delta\alpha_v$ to a positive value by setting the magnitude of the inter-plane distance in this manner, light in the first higher order mode (not laser light) is more likely to leak in a direction perpendicular to the two-dimensional photonic-crystal layer than light in the fundamental mode. Therefore, in a case where the gain of the active layer is uniform in the plane, the fundamental mode is selectively intensified by resonance in the two-dimensional photonic-crystal layer, and laser light of a single wavelength consisting of the fundamental mode is oscillated.

Note that, when an electric current is further supplied into the active layer in a state in which laser oscillation in the fundamental mode occurs, carriers in the active layer are consumed in a portion where the light intensity of the fundamental mode is strong, and nonuniformity occurs in the in-plane gain distribution. However, in general, when the radiation coefficient difference $\Delta\alpha_v$ is 1 cm$^{-1}$ or more, the above-described stable laser oscillation of a single wavelength can be maintained even if nonuniformity occurs in the gain distribution.

When the inter-plane distance is changed, the phase difference $\theta_{ref}$ between the first emission light and the second emission light changes from -180° to +180°.

The interaction between the in-plane guided light and the emission light increases or decreases sinusoidally with respect to the phase difference $\theta_{ref}$, and the interaction decreases as the phase difference $\theta_{ref}$ separates from 0° (approaches +180° or -180°). In this case, since the action of coupling a plurality of rays of in-plane guided light to each other via the emission light is weakened, the in-plane guided light in each direction propagates independently and tends to leak in the vertical direction. As a result, both the radiation coefficients $\alpha_{v0}$ and $\alpha_{v1}$ of the fundamental mode and the higher order mode and the radiation coefficient difference $\Delta\alpha_v$ thereof increase. Therefore, assuming that the phase difference $\theta_{ref}$ that realizes the lower limit value of the radiation coefficient difference $\Delta\alpha_v$ is set to $\pm\theta_{lim}$ ($\theta_{lim} > 0$), it suffices if the magnitude of the inter-plane distance is determined such that the phase difference $\theta_{ref}$ is smaller than $-\theta_{lim}$ or larger than $+\theta_{lim}$.

For the reflection layer, for example, a distributed Bragg reflector (DBR) used in a vertical cavity surface emitting laser (VCSEL) can be used. Alternatively, one of the pair of electrodes for supplying an electric current into the active layer may be formed of a material that reflects the second emission light, and the electrode may be used as the reflection layer.

A modified refractive index region may be composed of one region having a refractive index different from that of the base material, but is preferably composed of a modified refractive index region pair in which a first modified refractive index region and a second modified refractive index region having different planar areas are disposed apart from each other. By appropriately setting the positional relationship between the first modified refractive index region and the second modified refractive index region using such a modified refractive index region pair, it is possible to weaken the light in which the in-plane guided light is reflected by the modified refractive index region pair and the traveling direction changes by 180° by interference. In addition, by adjusting the sizes of the first modified refractive index region and the second modified refractive index region, it is possible to weaken both the light in which the traveling direction is changed by 180° in the modified refractive index region pair and the light in which the traveling direction is changed by 90° in the modified refractive index region pair by interference, and to obtain more complete vanishing interference of light in the plane. Therefore, in addition to the inter-plane distance, the magnitude of the interaction between the in-plane guided light and the emission light can also be set by the positional relationship between the first modified refractive index region and the second modified refractive index region and/or the magnitude thereof, whereby the value of the radiation coefficient difference $\Delta\alpha_v$ can also be set accordingly.

The inter-plane distance between the surfaces of the two-dimensional photonic-crystal layer and the reflection layer facing each other can be determined by the thickness of an intermediate layer disposed between the two layers. As such an intermediate layer, for example, a cladding layer made of a p-type or n-type semiconductor can be used. The cladding layer has a role of transporting holes or electrons supplied into the active layer from an electrode provided outside the reflection layer (on a side opposite to the two-dimensional photonic-crystal layer) (or constituting the reflection layer), and a role of suppressing in-plane guided light in the two-dimensional photonic-crystal layer from leaking from the two-dimensional photonic-crystal layer (in a form other than the emission light).

When such a cladding layer is provided, the two-dimensional photonic-crystal surface-emitting laser according to the present invention preferably has the following configuration. That is, it is preferable that the two-dimensional photonic-crystal surface-emitting laser according to the present invention further includes

a first cladding layer formed of a p-type semiconductor or an n-type semiconductor and provided between the two-dimensional photonic-crystal layer and the reflection layer, and a second cladding layer formed of a semiconductor having a carrier whose polarity is opposite to that of the first cladding layer and provided on a side opposite to the reflection layer side as viewed from the two-dimensional photonic-crystal layer, the first cladding layer and the second cladding layer being provided so as to sandwich the two-dimensional photonic crystal layer and the active layer,
wherein a product of a thickness and a refractive index of a layer other than the two-dimensional photonic-crystal layer between the first cladding layer and the second cladding layer is larger than a product of a thickness and a refractive index of the two-dimensional photonic-crystal layer.

The product of the thickness and the refractive index of each layer in the two-dimensional photonic-crystal surface-emitting laser means an effective optical path length of light in a direction perpendicular to the layer in the layer. By making the product of the effective thickness and the refractive index (that is, the optical path length in the vertical direction) of the layer other than the two-dimensional photonic-crystal layer between the first cladding layer and the second cladding layer larger than the product of the thickness and the refractive index (the same as above) of the two-dimensional photonic-crystal layer, the ratio of light distributed in the two-dimensional photonic-crystal layer is reduced as compared with the opposite case, and the action of combining the plurality of rays of in-plane guided light with each other via the emission light is weakened, so that the rays of in-plane guided light in respective directions propagate independently and are rather likely to leak in the vertical direction. As a result, both the radiation coefficients $\alpha_{v0}$ and $\alpha_{v1}$ of the fundamental mode and the higher order mode and the radiation coefficient difference $\Delta\alpha_v$ thereof increase.

Therefore, by setting the thickness and the refractive index of each layer between the first cladding layer and the second cladding layer as described above, the radiation coefficient difference $\Delta\alpha_v$ increases, and thus oscillation of the fundamental mode is more likely to occur, whereby laser light of a single wavelength can be oscillated more stably.

Note that not only the two-dimensional photonic-crystal layer and the active layer but also one or two or more other layers can be present between the first cladding layer and the second cladding layer. When such other layer(s) is(are) present, the "layer other than the two-dimensional photonic-crystal layer" refers to a plurality of layers obtained by combining the active layer and the one or two or more other layers. In this case, the "product of the thickness and the refractive index of the layer other than the two-dimensional photonic-crystal layer" corresponds to the value obtained by obtaining the product of the thickness and the refractive index of the layer in each of the plurality of layers and obtaining the sum of the values of the products.

As the "other layer(s)", a guide layer can be disposed between the first cladding layer and the second cladding layer on a side opposite to the two-dimensional photonic crystal layer as viewed from the active layer. The guide layer has a role of reducing a proportion of in-plane guided light distributed in the two-dimensional photonic-crystal layer, thereby weakening an action of coupling the plurality of rays of in-plane guided light to each other via the emission light.

ADVANTAGEOUS EFFECTS OF INVENTION

The present invention can provide a two-dimensional photonic-crystal surface-emitting laser capable of achieving oscillation of laser light of a single wavelength.

BRIEF DESCRIPTION OF DRAWINGS

Fig. 1A is a perspective view illustrating a first embodiment of a two-dimensional photonic-crystal surface-emitting laser according to the present invention, and Fig. 1B is a plan view of a two-dimensional photonic-crystal layer in the two-dimensional photonic-crystal surface-emitting laser.

Fig. 2 is a graph illustrating a result obtained by calculation of a relationship between a coefficient $\mu$ representing a magnitude of interaction generated with emission light when in-plane guided light is diffracted by 180° and a radiation coefficient difference $\Delta\alpha_v$ in the two-dimensional photonic-crystal surface-emitting laser according to the first embodiment.

Fig. 3A is an enlarged plan view of a modified refractive index region pair in the two-dimensional photonic-crystal surface-emitting laser of the first embodiment, and Fig. 3B is a graph illustrating a result of calculating a real part Re ($\kappa_{1D} + \kappa_{2D-}$) and an imaginary part Im ($\kappa_{1D} + \kappa_{2D-}$) of a sum of a one-dimensional coupling coefficient $\kappa_{1D}$ and a two-dimensional coupling coefficient $\kappa_{2D-}$ for a plurality of examples having different parameters $\delta a$ and $2x$ illustrated in Fig. 3A.

Fig. 4 is a graph illustrating a result obtained by calculating a relationship between a phase difference $\theta_{ref}$ between first emission light and second emission light and a coefficient $\mu$ in the two-dimensional photonic-crystal surface-emitting laser of the first embodiment.

Figs. 5A and 5B are graphs each illustrating a result obtained by calculating a relationship between a phase difference $\theta_{ref}$ and a threshold gain difference in the two-dimensional photonic-crystal surface-emitting laser of the first embodiment.

Fig. 6 is a graph illustrating a result obtained by calculating electric current-laser light output characteristics in the two-dimensional photonic-crystal surface-emitting laser of the first embodiment.

Fig. 7 is a graph illustrating a result obtained by calculating an oscillation spectrum in the two-dimensional photonic-crystal surface-emitting laser of the first embodiment.

Fig. 8 is a graph illustrating an example of a spectrum of spontaneous emission light from the two-dimensional photonic-crystal surface-emitting laser of the first embodiment.

Fig. 9 is a perspective view illustrating a second embodiment of a two-dimensional photonic-crystal surface-emitting laser according to the present invention.

Fig. 10 is a graph illustrating results obtained by calculating ratios $\Gamma_{pc}$ and $\Gamma_{act}$ of light respectively present in a two-dimensional photonic-crystal layer and an active layer during operation in the two-dimensional photonic-crystal surface-emitting laser of the second embodiment.

Fig. 11 is a graph illustrating a result obtained by calculating a relationship between a phase difference $\theta_{ref}$ between first emission light and second emission light and a coefficient $\mu$ in a two-dimensional photonic-crystal surface-emitting laser (an example in which a thickness of a guide layer is 300 nm) of the second embodiment.

Fig. 12 is a graph illustrating a result obtained by calculating electric current-laser light output characteristics in a two-dimensional photonic-crystal surface-emitting laser (an example in which a thickness of the guide layer is 300 nm and phase difference $\theta_{ref}$ is 0°) of the second embodiment.

Fig. 13 is a graph illustrating a result obtained by calculating an oscillation spectrum in a two-dimensional photonic-crystal surface-emitting laser (an example in which a thickness of the guide layer is 300 nm and phase difference $\theta_{ref}$ is 0°) of the second embodiment.

Fig. 14 is a perspective view of a two-dimensional photonic-crystal surface-emitting laser of a modification.

## DESCRIPTION OF EMBODIMENTS

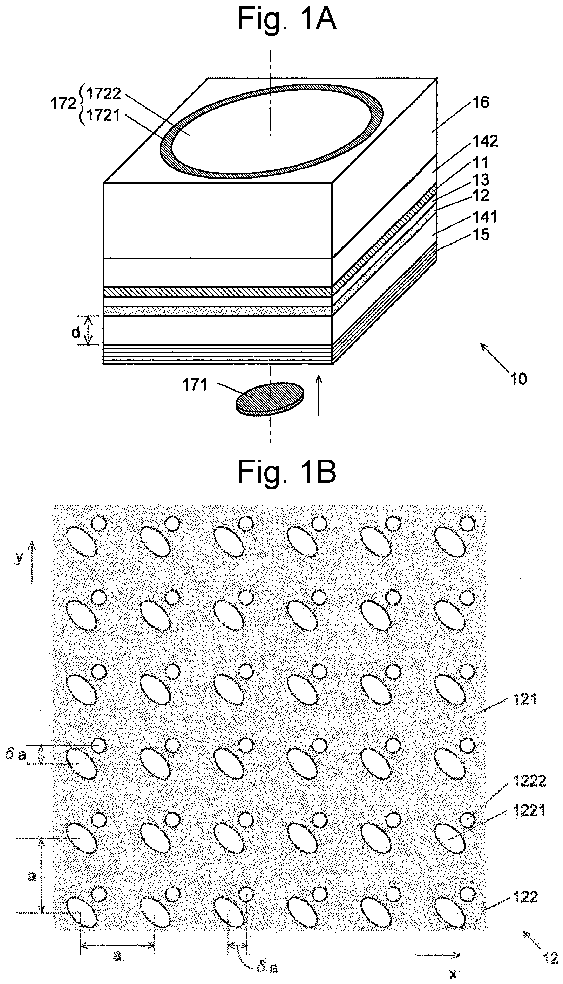

An embodiment of a two-dimensional photonic-crystal surface-emitting laser according to the present invention will be described with reference to Figs. 1A to 14.

[1] Configuration of two-dimensional photonic-crystal surface-emitting laser of first embodiment

As illustrated in Fig. 1A, a two-dimensional photonic-crystal surface-emitting laser 10 of a first embodiment has a configuration in which a first electrode 171, a reflection layer 15, a first cladding layer 141, a two-dimensional photonic-crystal layer 12, a spacer layer 13, an active layer 11, a second cladding layer 142, a substrate 16, and a second electrode 172 are laminated in this order. The order of the active layer 11 and the two-dimensional photonic-crystal layer 12 may be opposite to that described above. In Fig. 1A, for convenience, the first electrode 171 is illustrated as a lower side, and the second electrode 172 is illustrated as an upper side, but the orientation of the two-dimensional photonic-crystal surface-emitting laser 10 at the time of use is not limited to that illustrated in Fig. 1A. Hereinafter, the configurations of the electrodes and each layer will be described.

The active layer 11 emits light within a specific wavelength band upon receiving electric charges supplied from the first electrode 171 and the second electrode 172. In the first embodiment, the material of the active layer 11 is an InGaAs/AlGaAs multiple quantum well (emission wavelength band: 935 to 945 nm), and the thickness of the active layer 11 is 90 nm.

As illustrated in Fig. 1B, in the two-dimensional photonic-crystal layer 12, modified refractive index region pairs 122 having a refractive index different from that of a plate-like base material 121 are disposed in a square lattice pattern. A period length $a$ of the square lattice is set to 278 nm corresponding to the wavelength within the emission wavelength band in the active layer 11 in consideration of the influence of the refractive index of the modified refractive index region pairs 122 on the refractive index of the entire two-dimensional photonic-crystal layer 12. The material of the base material 121 is p-type GaAs, the planar dimensions are the same as those of the active layer 11 and the like, and the thickness is 160 nm. The period length $a$ can be changed as appropriate according to the material of the base material 121 and the emission wavelength band in the active layer 11.

The modified refractive index region pairs 122 are each made of a first modified refractive index region 1221 and a second modified refractive index region 1222.

In the first embodiment, the first modified refractive index region 1221 and the second modified refractive index region 1222 both are made of holes formed in the base material 121, and the planar shape of the first modified refractive index region 1221 is elliptical and the planar shape of the second modified refractive index region 1222 is circular. The planar area of the first modified refractive index region 1221 is larger than that of the second modified refractive index region 1222. The centroid of the first modified refractive index region 1221 and the centroid of the second modified refractive index region 1222 in one modified refractive index region pair 122 are disposed to be deviated by the same distance $\delta a$ in the x direction and the y direction, which are two directions in which lattice points of the square lattice are disposed with the period length a. As in the invention described in Patent Literature 1, the magnitude $\delta a$ of these deviations is preferably in the range of 0.15$a$ to 0.35$a$ in both the x direction and the y direction. The minor axis of the ellipse of the first modified refractive index region 1221 is inclined by 45° from the x direction and the y direction, and the centroid of the second modified refractive index region 1222 is disposed on an extension line of the minor axis (a straight line y = x on a plane having the x direction and the y direction as coordinate axes). Details of the lengths of the major axis and the minor axis of the ellipse of the first modified refractive index region 1221 and the diameter of the second modified refractive index region 1222 will be described in [3-2]. Note that one modified refractive index region may be used instead of one modified refractive index region pair 122. In addition, in the modified refractive index region (pair), a member having a refractive index different from that of the base material 121 may be used instead of the hole.

The reflection layer 15 reflects laser light entering from the two-dimensional photonic-crystal layer 12 through the first cladding layer 141, and a distributed Bragg reflector (DBR) is used in the first embodiment. The DBR used in the first embodiment is obtained by alternately laminating a first layer made of $Al_{0.1}Ga_{0.9}As$ and having a thickness of 68 nm and a second layer made of $Al_{0.9}Ga_{0.1}As$ and having a thickness of 78 nm to laminate 14 layers of each layer. The thicknesses of the first layer and the second layer are set such that the sum of the thicknesses of the two layers is 1/2 of the in-medium wavelength of the incident laser light. With such a configuration, the optical path difference between the laser light reflected by a certain first layer and the laser light reflected by another first layer is an integral multiple of the wavelength, so that the reflected light is intensified by interference (the same applies to the laser light reflected by a certain second layer and the laser light reflected by another second layer).

The first cladding layer 141 is made of a p-type semiconductor in order to supply holes from the first electrode 171 into the active layer 11 (note that the reason why the material of the base material 121 of the two-dimensional photonic-crystal layer 12 is p-type GaAs, which is a p-type semiconductor, is also the same as above). In the first embodiment, p-type $Al_{0.37}Ga_{0.63}As$ is used as the material of the first cladding layer 141, but other p-type semiconductors may be used. In the first embodiment, the thickness of the first cladding layer 141 is set to a certain value in the range of 930 nm to 1030 nm, but the present invention is not limited thereto. This thickness corresponds to a distance (the inter-plane distance) d between the surfaces of the two-dimensional photonic-crystal layer 12 and the reflection layer 15 facing each other. Details of a method for determining the inter-plane distance (thickness of the first cladding layer 141) *d* will be described in section [3-1].

The second cladding layer 142 is made of an n-type semiconductor in order to supply electrons from the second electrode 172 into the active layer 11. In the first embodiment, n-type $Al_{0.37}Ga_{0.63}As$ is used as the material of the second cladding layer 142, but other n-type semiconductors may be used. The thickness of the second cladding layer 142 is not particularly limited, but is set to 1100 nm in the first embodiment.

As the substrate 16, the substrate sufficiently thicker than other layers are used in order to maintain the mechanical strength of the entire two-dimensional photonic-crystal surface-emitting laser 10. In the first embodiment, this thickness is set to 150 $\mu$m (150000 nm). As a material of the substrate 16, an n-type semiconductor is used for the same reason as the second cladding layer 142. In the first embodiment, n-type GaAs is used, but other n-type semiconductors may be used.

The spacer layer 13 is provided to prevent electrons supplied from the second electrode 172 from passing through the active layer 11 (whereby the electrons are bonded with holes on the first electrode 171 side rather than the active layer 11) while allowing holes supplied from the first electrode 171 to pass and to be introduced into the active layer 11. In the first embodiment, as the spacer layer 13, the spacer layer 13 having a two-layer structure in which a layer of i-type (intrinsic semiconductor) $Al_{0.45}Ga_{0.55}As$ having a thickness of 25 nm is disposed on the active layer 11 side and a layer of i-type GaAs having a thickness of 90 nm is disposed on the two-dimensional photonic-crystal layer 12 side is used.

The first electrode 171 has a circular shape and is provided in a range narrower than a region where the two-dimensional photonic crystal is formed in the two-dimensional photonic-crystal layer 12. The second electrode 172 has a configuration in which the center of a circular sheet metal material is hollowed out in a circular shape. A portion where the sheet member is hollowed out is referred to as window portion 1722, and a portion where the sheet member is left is referred to as frame portion 1721. Note that, in Fig. 1A, in order to illustrate the first electrode 171, the first electrode 171 is illustrated to be separated downward from the reflection layer 15, but actually, the first electrode 171 is in contact with the lower surface of the reflection layer 15.

[2] Operation of two-dimensional photonic-crystal surface-emitting laser of first embodiment

Next, an operation of the two-dimensional photonic-crystal surface-emitting laser 10 of the first embodiment will be described. By applying a predetermined voltage between the first electrode 171 and the second electrode 172, an electric current is supplied into the active layer 11 from both electrodes. As a result, light emission having a wavelength within a predetermined wavelength band corresponding to the material of the active layer 11 is generated from the active layer 11. The light emission thus generated is selectively amplified by resonance of light having a resonance wavelength corresponding to the period length a of the square lattice in the two-dimensional photonic-crystal layer 12, and laser oscillation occurs. Note that, as in the case where the thickness of each layer is set as in the above example, by making the distance between the first electrode 171 and the active layer 11 sufficiently shorter than the distance between the second electrode 172 and the active layer 11, the range in which light emission occurs when an electric current is supplied into the active layer is substantially equal to the shape of the first electrode 171.

The oscillated laser light is emitted from both surfaces of the two-dimensional photonic-crystal layer 12 in a direction perpendicular to the two-dimensional photonic-crystal layer 12. Among them, the laser light (second emission light) emitted to the first cladding layer 141 side is reflected by the reflection layer 15, passes through the two-dimensional photonic-crystal layer 12, and is directed to the second cladding layer 142 side. Then, emission light is generated in which the second emission light interferes with first emission light that is laser light directly emitted to the second cladding layer 142 side of the two-dimensional photonic-crystal layer 12, and the emission light is emitted from the window portion 1722 of the second electrode 172 to the outside. Herein, since the state of the emission light depends on the phase difference $\theta_{ref}$ between the first emission light and the second emission light determined by the inter-plane distance, and the emission light interacts with the in-plane guided light in the two-dimensional photonic-crystal layer 12 to affect the radiation coefficient $\alpha_{v0}$ of the fundamental mode and the radiation coefficient $\alpha_{v1}$ of the first higher order mode, and it is better that the radiation coefficient difference $\Delta\alpha_v (= \alpha_{v1} - \alpha_{v0})$ is larger in order to obtain the laser light of the single wavelength of the fundamental mode, it is necessary to appropriately design the inter-plane distance in order to obtain the laser light of the single wavelength of the fundamental mode. Hereinafter, the design of the inter-plane distance and the design of the modified refractive index region pair 122 related to the design will be described.

[3] Details of design of two-dimensional photonic-crystal surface-emitting laser of first embodiment

[3-1] Example of design of inter-plane distance (thickness of first cladding layer 141) *d*

Hereinafter, the design of the inter-plane distance will be described in detail by exemplifying a case where the modified refractive index regions are arranged on a square lattice as in the two-dimensional photonic-crystal layer 12 in the first embodiment.

In the two-dimensional photonic crystal in which the modified refractive index regions are arranged on a square lattice, the radiation coefficient $\alpha_v$ is represented by a theoretical formula of a complex eigenfrequency of a photonic band called "mode A" having the lowest energy. [Mathematical formula 1]

$$\alpha_v = \frac{\mu}{(\mu^2 + R^2)} \left[ I^2 + \left( \frac{\Delta k}{\sqrt{2}} \right)^2 \right] \quad \cdots (1)$$

In formula (1), R is a real part of an effective coupling coefficient, I is an imaginary part of the effective coupling coefficient, and are represented respectively by

$$R = \mathrm{Re}[(\kappa_{1D} + \kappa_{2D\text{-}})\exp(\text{-}i\theta_{PC})] \ \dots \ (2)$$

$$I = \mathrm{Im}[(\kappa_{1D} + \kappa_{2D\text{-}})\exp(\text{-}i\theta_{PC})] \ \dots \ (3).$$

The $\kappa_{1D}$ in the formulas (2) and (3) is a one-dimensional coupling coefficient (Hermitian component) representing an interaction between in-plane guided light guided in one direction and in-plane guided light obtained as a traveling direction of the in-plane guided light is changed by 180° (diffracted by 180°) by being reflected by the modified refractive index regions. The $\kappa_{2D\text{-}}$ represents reflection (90° diffraction) with respect to the straight line y = -x among two-dimensional coupling coefficients representing the interaction between the in-plane guided light guided in one direction and the light whose traveling direction is changed by 90° by the modified refractive index regions. Note that, among the two-dimensional coupling coefficients, a coefficient representing reflection (90° diffraction) with respect to the straight line y = x is represented by $\kappa_{2D+}$. These $\kappa_{1D}$, $\kappa_{2D\text{-}}$, and $\kappa_{2D+}$ are obtained based on the shape of the modified refractive index region (in the first embodiment, the positional relationship between the first modified refractive index region 1221 and the second modified refractive index region 1222 in the modified refractive index region pair 122 and their shapes). $\theta_{PC}$ represents an additional phase when the in-plane guided light guided in the negative direction in the x direction is diffracted to the in-plane guided light guided in the positive direction in the x direction via the emission light, and $\theta_{PC}$ is approximately 165° when the center point between the centroid of the first modified refractive index region and the centroid of the second modified refractive index region is disposed at the center of the unit lattice. In addition, $\mu$ in the formula (1) is a non-Hermitian coupling coefficient when the rays of in-plane guided light are coupled to each other via the emission light, and is approximated by a formula (4), depending on an interference phase difference $\theta_{ref}$ between the first emission light and the second emission light determined by the inter-plane distance d.

$$\mu = \mu_{noref}(1 + \cos(\theta_{ref})) \ \dots \ (4)$$

Herein, $\mu_{noref}$ is a value of $\mu$ in a case where there is no reflection layer. $\Delta k$ represents a shift of a wave number from a $\Gamma$ point that is an origin in a wave number space to a $\Gamma$-M direction, and corresponds to a resonance wave number generated in a two-dimensional photonic crystal having a finite size. Note that, in the formula (1), approximation is performed assuming that |I| and |$\Delta k$| are sufficiently smaller than |R| and |$\mu$|.

For example, in a case where the diameter of the inscribed circle in the range in which light emission occurs when an electric current is supplied into the active layer is L (for example, the range is a circle having a diameter L or a square having a side length L), the resonance wave number $\Delta k_0$ of the fundamental mode when the light emission resonates in the two-dimensional photonic-crystal layer 12 is $\pi/L$, and the resonance wave number $\Delta k_1$ of the first higher order mode is $2\pi/L$. When these $\Delta k_0$ and $\Delta k_1$ are substituted into the formula (1), the radiation coefficient $\alpha_{v0}$ of the fundamental mode and the radiation coefficient $\alpha_{v1}$ of the first higher order mode are represented as follows.

[Mathematical formula 2]

$$\alpha_{v0} = \frac{\mu}{(\mu^2 + R^2)} \left( I^2 + \frac{\pi^2}{2L^2} \right) \quad \cdots (5)$$

$$\alpha_{v1} = \frac{\mu}{(\mu^2 + R^2)} \left( I^2 + \frac{2\pi^2}{L^2} \right) \quad \cdots (6)$$

Therefore, the radiation coefficient difference $\Delta\alpha_v = (\alpha_{v1} - \alpha_{v0})$ is represented by the following.
[Mathematical formula 3]

$$\Delta\alpha_v = \frac{\mu}{(\mu^2 + R^2)} \left( \frac{3\pi^2}{2L^2} \right) \quad \cdots (7)$$

As described above, $\mu$ and R in the formula (7) include $\kappa_{1D}$ and $\kappa_{2D\text{-}}$ based on the shape of the modified refractive index region, and the phase difference $\theta_{ref}$ based on the thickness (inter-plane distance) d and the refractive index of the first cladding layer 141. Therefore, when the phase difference $\theta_{ref}$ is determined such that the radiation coefficient difference $\Delta\alpha_v$ is 1 cm$^{-1}$ or more in

the formula (7) after $\kappa_{1D}$ and $\kappa_{2D-}$ are obtained on the basis of the shape of the modified refractive index region, the thickness (inter-plane distance) $d$ of the first cladding layer 141 can be set. Note that, in the formula (7), $\Delta\alpha_v$ is inversely proportional to $\mu$ when $R = 0$ cm$^{-1}$ (or a value sufficiently smaller than $\mu$), and thus, regardless of the value of the diameter L set, there is a value range of $\mu$ in which the radiation coefficient difference $\Delta\alpha_v$ is 1 cm$^{-1}$ or more in the formula (7), and further, according to the formula (4), there is always a corresponding value of the phase difference $\theta_{ref}$. For example, in the case of L = 10 mm, $\Delta\alpha_v$ can be 1 cm$^{-1}$ or more when the value of $\mu$ is set to 14.8 cm$^{-1}$ or less. However, according to theoretical calculation, since the upper limit value of $\Delta\alpha_v$ is given as $3^{1/2}\mu$, $\mu$ needs to be $3^{-1/2}$ cm$^{-1}$ or more in order to set $\Delta\alpha_v$ to 1 cm$^{-1}$ or more.

[3-2] Design of modified refractive index region pair 122

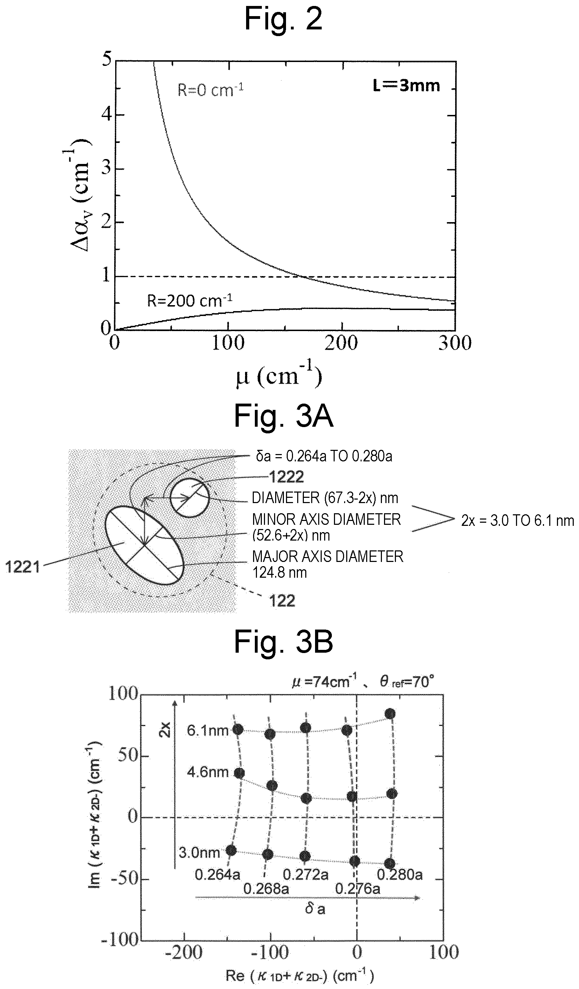

As is clear from the formula (7), the radiation coefficient difference $\Delta\alpha_v$ increases as R approaches 0 cm$^{-1}$, so that laser light having a single wavelength is likely to be oscillated. The graph of Fig. 2 illustrates a result of calculating the radiation coefficient difference $\Delta\alpha_v$ within a range of $\mu$ of 0 to 300 cm$^{-1}$ for each of the cases of L = 3 mm, R = 0 cm$^{-1}$, and R = 200 cm$^{-1}$. From this graph, when $\mu$ is any value, the radiation coefficient difference $\Delta\alpha_v$ is higher in the case of R = 0 cm$^{-1}$ than in the case of R = 200 cm$^{-1}$. R of 0 cm$^{-1}$ means that both the light diffracted by 180° and the light diffracted by 90° in the modified refractive index region pair 122 are canceled by interference, thereby preventing the light from being localized in a partial region in the two-dimensional photonic crystal.

Therefore, the shape of the modified refractive index region (the modified refractive index region pair 122) may preferably be designed so that R is as close as possible to 0 cm$^{-1}$. In the example illustrated in Fig. 3A, the lattice constant a was set to 278 nm, the major axis diameter of the first modified refractive index region 1221 was set to 124.8 nm, the minor axis diameter of the first modified refractive index region 1221 was set to (52.6 + 2x) nm, and the diameter of the second modified refractive index region 1222 was set to (67.3 - 2x) mm, and then, the value of 2x was changed in three ways within the range of 3.0 to 6.1 nm, and the positional deviation $\delta a$ between the first modified refractive index region 1221 and the second modified refractive index region 1222 in the x direction and the y direction in the modified refractive index region pair 122 was changed in five ways between 0.264a to 0.280a. In each of the 15 ways in total, the values of the real part Re $(\kappa_{1D} + \kappa_{2D-})$ and the imaginary part Im $(\kappa_{1D} + \kappa_{2D-})$ of $(\kappa_{1D} + \kappa_{2D-})$ were obtained. The positions of the first modified refractive index region 1221 and the second modified refractive index region 1222 were defined by the position of the centroid of their planar shapes. In the case of $\mu = 74$ cm$^{-1}$ ($\theta_{ref} = 70°$) exemplified in Fig. 3B, among 15 cases, when

$\delta a = 0.276a$ and $2x = 4.6$ nm, the values of Re($\kappa_{1D} + \kappa_{2D-}$) and Im($\kappa_{1D} + \kappa_{2D-}$) are closest to 0, and the value of R represented by the formula (2) is also closest to 0, and thus $\delta a = 0.276a$ and $2x = 4.6$ nm are preferable.

[3-3] Calculation example of $\mu$ and $\Delta\alpha_v$

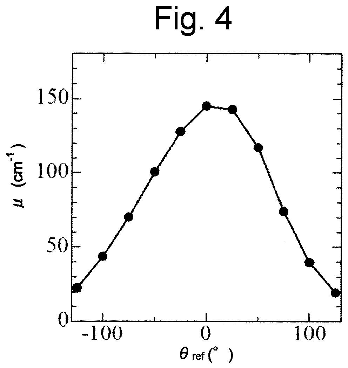

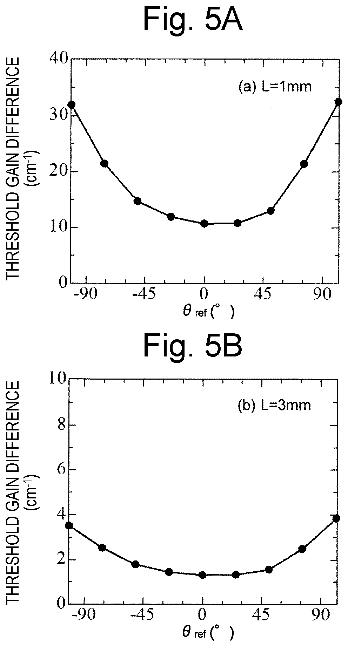

Next, in a case where the modified refractive index region pair 122 in which $\delta a$ and 2x are determined so that both Re($\kappa_{1D} + \kappa_{2D-}$) and Im($\kappa_{1D} + \kappa_{2D-}$) are closest to 0 is used, the result of calculating $\mu$ while changing (that is, the inter-plane distance d is changed) the phase difference $\theta_{ref}$ between the first emission light and the second emission light is illustrated in the graph of Fig. 4, and the result of calculating the threshold gain difference (similar to the radiation coefficient difference $\Delta\alpha_v$, a parameter indicating easiness of laser oscillation in the fundamental mode with respect to the first higher order mode) is illustrated in Figs. 5A and 5B. The threshold gain difference was calculated assuming that the first electrode 171 was a circle having a diameter L = 1 mm (in the case of Fig. 5A) or 3 mm (in the case of Fig. 5B) and an electric current was supplied into the entire region of the active layer corresponding to the circle. From these graphs, it can be seen that as $\theta_{ref}$ is more positively or negatively separated from 0°, $\mu$ becomes smaller (Fig. 4), and the threshold gain difference becomes larger in both cases of L = 1 mm and 3 mm (Figs. 5A and 5B), that is, laser light having a single wavelength is likely to be emitted.

In particular, according to the formula (4), by setting $|\theta_{ref}|$ to 90° or more, the value of $\mu$ in a case where the reflection layer is provided can be set to be equal to or less than the value of $\mu$ ($\mu_{noref}$) in a case where the reflection layer is not provided, so that it is possible to increase the threshold gain difference as compared with a case where the reflection layer is not provided. However, when $|\theta_{ref}| = 180°$, the first reflected light and the second reflected light disappear due to interference. Therefore, $|\theta_{ref}|$ is set to less than 180°.

[3-4] Calculation example of oscillation spectrum

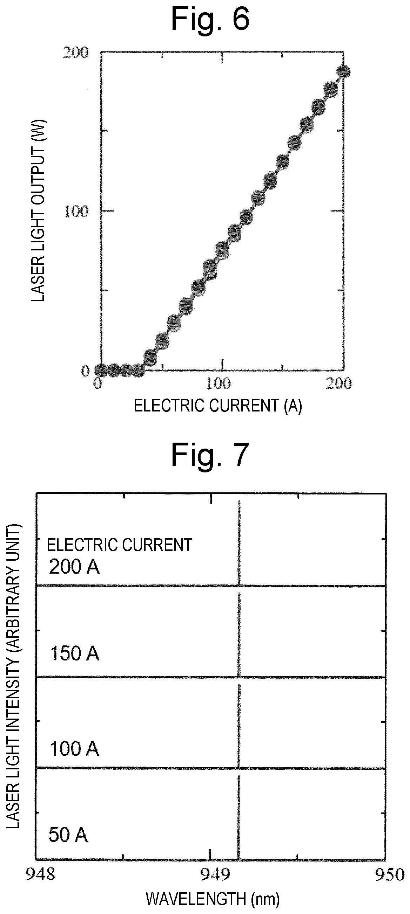

Next, for a case where the lattice constant was a = 279 nm, the parameter of the modified refractive index region pair 122 was $\delta a = 0.256a$, $2x = 5.6$ nm, the phase difference $\theta_{ref}$ between the first emission light and the second emission light was -90° ($\mu = 88$ cm$^{-1}$), and the diameter L of the region where the two-dimensional photonic crystal was formed was 3 mm, the electric current-laser light output characteristics and the oscillation spectrum were obtained by calculation. The threshold gain difference under these conditions is 1.27 cm$^{-1}$. The calculation result of the electric current-laser light output characteristics is illustrated in the graph of Fig. 6, and the oscillation spectrum is illustrated in the graph of Fig. 7. The electric current-laser light output characteristics were calculated assuming a case where the electric current was uniformly supplied to the region where the two-dimensional photonic crystal was formed and a case where the electric current was non-uniformly supplied, but there was almost no difference between them, and thus, in Fig. 6, all the calculation results are illustrated in an overlapping manner without distinction.

As illustrated in the graph of Fig. 6, when the electric current exceeds a threshold (about 30 A), the output of the laser light increases linearly with respect to the increase in the electric current. The oscillation spectrum was calculated within a range until the electric current reached 200 A at the maximum, and an oscillation spectrum of a single wavelength was obtained at any electric current value.

[3-5] Method of obtaining $\mu$ and R by experiment

As described in section [3-1] above, the radiation coefficient difference $\Delta\alpha_v$ depends on the real part R of the effective coupling coefficient and the coefficient $\mu$ representing the magnitude of interaction with the emission light generated when the in-plane guided light is diffracted by 180°, and these R and $\mu$ depend on the phase difference $\theta_{ref}$, the one-dimensional coupling coefficient $\kappa_{1D}$, and the two-dimensional coupling coefficient $\kappa_{2D}$. When the one-dimensional coupling coefficient and the two-dimensional coupling coefficient are unknown, R and $\mu$ can be obtained by experiments as follows.

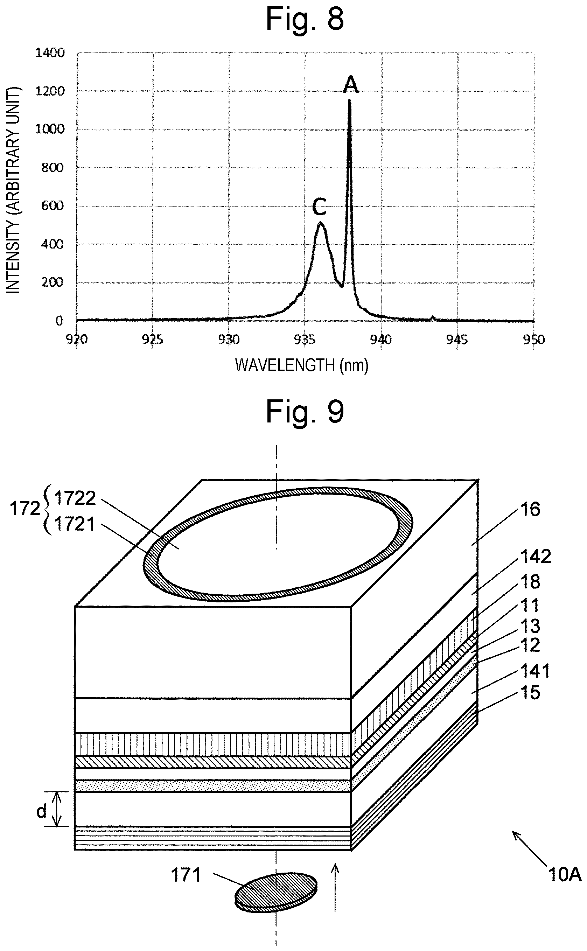

In the two-dimensional photonic-crystal surface-emitting laser 10, spontaneous light emission (not laser light) occurs by supplying an electric current smaller than an electric current that causes laser oscillation. In addition to the light derived from a band A that is a photonic band contributing to laser oscillation, the spontaneous light emission includes light derived from a band C that has the same polarization direction as that of the light emission of the band A and does not contribute to laser oscillation because of a large loss. Therefore, a polarizer that passes the polarized light of the band A and the band C (the direction of the straight line of y = -x on the graph with the x direction and the y direction as coordinate axes) is disposed on the second electrode 172, and the spectrum of the spontaneous emission light is measured. An example of the measured spectrum of the spontaneous emission light is illustrated in Fig. 8. In this spontaneous emission spectrum, a peak having a wavelength $\lambda_A$ (the same wavelength as that of the laser light) and a full width at half maximum $\Delta\lambda_A$ derived from the band A and a peak having a wavelength $\lambda_C$ and a full width at half maximum $\Delta\lambda_C$ derived from the band C are observed. From these $\lambda_A$, $\Delta\lambda_A$, $\lambda_C$, and $\Delta\lambda_C$, R and $\mu$ are represented as follows.

[Mathematical formula 4]

$$R = \pi\, n_g \left| \frac{1}{\lambda_C} - \frac{1}{\lambda_A} \right| \quad \cdots(8)$$

$$\mu = \frac{\pi\, n_g}{2} \left| \frac{\Delta\lambda_C}{\lambda_C^{\,2}} + \frac{\Delta\lambda_A}{\lambda_A^{\,2}} \right| \quad \cdots(9)$$

Herein, $n_g$ is a group refractive index (defined by a value obtained by dividing the light speed c by the group velocity $v_g$ of a light wave flux).

[4] Two-dimensional photonic-crystal surface-emitting laser according to second embodiment

As illustrated in Fig. 9, a two-dimensional photonic-crystal surface-emitting laser 10A of a second embodiment has a configuration in which a first electrode 171, a reflection layer 15, a first cladding layer 141, a two-dimensional photonic-crystal layer 12, a spacer layer 13, an active layer 11, a guide layer 18, a second cladding layer 142, a substrate 16, and a second electrode 172 are laminated in this order.

Among these layers, the guide layer 18 is a layer that is not included in the two-dimensional photonic-crystal surface-emitting laser 10 of the first embodiment, and is a layer disposed between the first cladding layer 141 and the second cladding layer 142 on the side opposite to the two-dimensional photonic-crystal layer 12 as viewed from the active layer 11. The guide layer 18 has a role of reducing a proportion of in-plane guided light distributed in the two-dimensional photonic-crystal layer 12, thereby weakening an action of coupling a plurality of rays of in-plane guided light to each other via the emission light. In the present embodiment, the guide layer 18 is made of $Al_{0.15}Ga_{0.85}As$ (refractive index 3.45), which is an n-type semiconductor. The thickness of the guide layer 18 is set to a value between 80 and 400 nm according to a setting value of a distance (the inter-plane distance) d between the surfaces of the two-dimensional photonic-crystal layer 12 and the reflection layer 15 facing each other.

The two-dimensional photonic-crystal layer 12 has the same configuration as that of the first embodiment (refer to Fig. 1B). Herein, the period length *a* of the square lattice is 278 nm, and the filling factor of the modified refractive index region pairs 122 (the ratio of the volume occupied by the modified refractive index region pairs 122 in the two-dimensional photonic-crystal layer 12) is 8%. The refractive index of p-type GaAs, which is the material of the base material 121, is 3.55, and the refractive index of air, which is the material of the modified refractive index region pairs 122, is substantially 1. From these dimensions and the refractive index of each material, the refractive index of the entire two-dimensional photonic-crystal layer 12 is 3.42.

The configurations of the first electrode 171, the reflection layer 15, the first cladding layer 141, the spacer layer 13, the active layer 11, the second cladding layer 142, the substrate 16, and the second electrode 172 are similar to those in the first embodiment. In particular, focusing on a layer between the first cladding layer 141 and the second cladding layer 142, the active layer 11 is made of an InGaAs/AlGaAs multiple quantum well and has an average refractive index of 3.49 and a thickness of 90 nm. In addition, the spacer layer 13 has a two-layer structure including a layer made of i-type $Al_{0.45}Ga_{0.55}As$ and having a thickness of 25 nm and a layer made of i-type GaAs and having a thickness of 90 nm, and has an average refractive index of 3.49.

From these parameters, the value of the product of the thickness and the refractive index of the two-dimensional photonic-crystal layer 12 is 547.2 nm. The value of the product of the thickness and the refractive index of each of the spacer layer 13, the active layer 11, and the guide layer 18, which are layers other than the two-dimensional photonic-crystal layer 12 among the layers between the first cladding layer 141 and the second cladding layer 142 (a value of a product of the thickness and the refractive index is obtained for each of the three layers, and a sum of the three values is obtained) is in the range of 991.5 to 2095.5 nm according to the thickness of the guide layer 18. Therefore, when the latter value is within any range, the latter value is larger than the former value.

Note that the material and the thickness of each layer described herein are merely examples, and can be changed as appropriate within a range in which the value of the product of the thickness and the refractive index of the spacer layer 13, the active layer 11, and the guide layer 18 is larger than the value of the product of the thickness and the refractive index of the two-dimensional photonic-crystal layer 12.

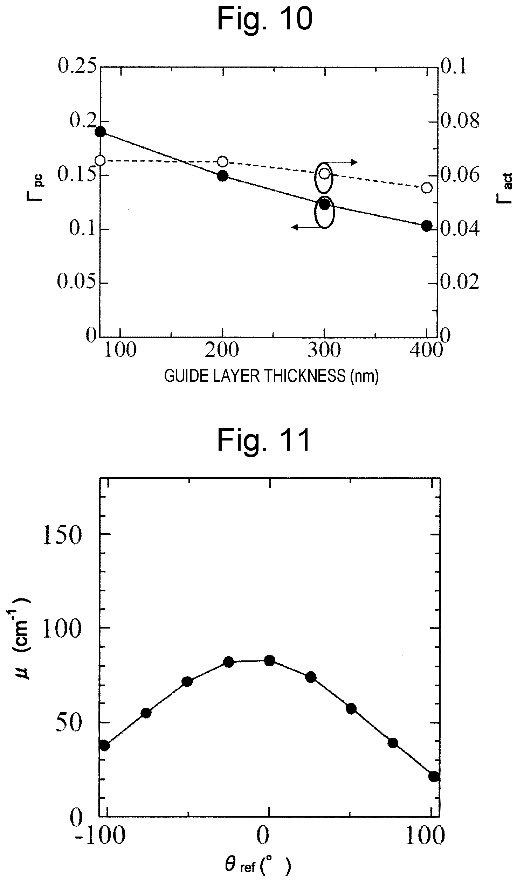

For the two-dimensional photonic-crystal surface-emitting laser 10A of the second embodiment, the ratio $\Gamma_{pc}$ of light existing in the two-dimensional photonic-crystal layer 12 and the ratio $\Gamma_{act}$ of light existing in the active layer 11 during operation were obtained by calculation. This calculation was performed for four cases where the thickness of the guide layer 18 was 80 nm, 200 nm, 300 nm, and 400 nm. Fig. 10 illustrates the calculation results. In addition, when calculation was performed for a case where there was no guide layer 18, $\Gamma_{pc}$ was 0.222, and $\Gamma_{act}$ was 0.065. From these calculation results, it can be seen that the value of $\Gamma_{pc}$ (black circles in Fig. 10) decreases and the ratio of the in-plane guided light confined in the two-dimensional photonic-crystal layer 12 decreases in the case where the guide layer 18 is present than in the case where the guide layer 18 is not present and as the thickness of the guide layer increases. As a result, the action of combining the plurality of rays of in-plane guided light with each other via the emission light is weakened, whereby the in-plane guided light in each direction propagates independently and is likely to leak in the direction perpendicular to the two-dimensional photonic-crystal layer 12. As a result, it is considered that as the thickness of the guide layer 18 increases, the radiation coefficients $\alpha_{v0}$ and $\alpha_{v1}$ of the fundamental mode and the higher order mode increase, and further, the radiation coefficient difference $\Delta\alpha_v$ also increases accordingly, so that oscillation of laser light of a single wavelength is easily obtained. Note that, although $\Gamma_{act}$ slightly decreases as the thickness of the guide layer 18 increases, a difference due to the presence or absence of the guide layer 18 and a difference in thickness is not significantly observed as $\Gamma_{pc}$.

Next, with respect to the two-dimensional photonic-crystal surface-emitting laser 10A of the second embodiment, Fig. 11 illustrates a result of calculating a coefficient $\mu$ representing the magnitude of the interaction generated between the in-plane guided light and the emission light when the in-plane guided light is diffracted by 180° while changing the phase difference $\theta_{ref}$ between the first emission light and the second emission light. In this calculation, the thickness of the guide layer 18 was set to 300 nm. Comparing this calculation result with Fig. 4 illustrating a result of performing similar calculation in the first embodiment, it is considered that the value of $\mu$ is suppressed in the second embodiment in a range in which the phase difference $\theta_{ref}$ is about -60° to +60°, in which the value of $\mu$ cannot be sufficiently suppressed in the first embodiment, and the radiation coefficient difference $\Delta\alpha_v$ is thereby increased, so that laser light of a single wavelength is likely to be oscillated.

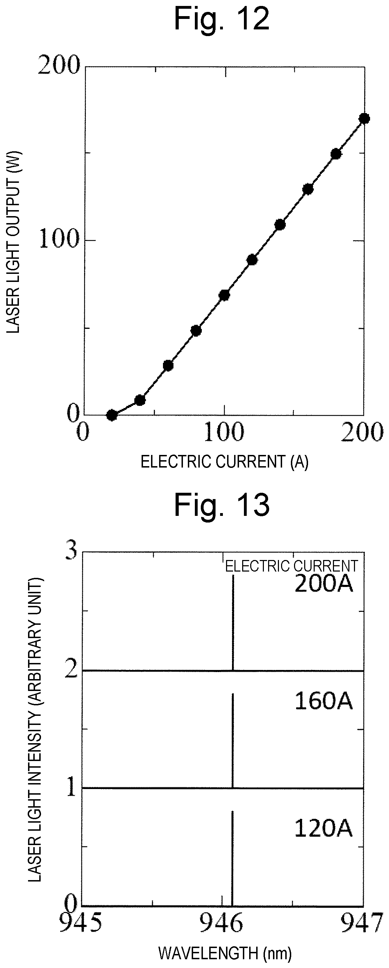

Next, for the second embodiment, the electric current-laser light output characteristics and the oscillation spectrum were obtained by calculation. In these calculations, the thickness of the guide layer 18 was set to 300 nm, and the phase difference $\theta_{ref}$ was 0°. It is noted that in this calculation, the two-dimensional photonic-crystal layer having the modified refractive index region pair 122 similar to that of the two-dimensional photonic-crystal layer 12 in the first embodiment was used, the value of $\delta a$ was set to 0.259a, and the value of 2x was set to 3.0 nm. The radiation coefficient difference $\Delta\alpha_v$ in this case was 1.33 cm$^{-1}$. Fig. 12 illustrates a calculation result of the electric current-laser light output characteristics, and Fig. 13 illustrates a calculation result of the oscillation spectrum. From these calculation results, in the second embodiment, it has been confirmed that laser light having a single wavelength can be obtained within a range in which the electric current to be supplied is up to 200 A and the output is up to 170 W under a disadvantageous condition for suppressing the radiation coefficient difference $\Delta\alpha_v$ in which $\theta_{ref}$ is 0°.

In the example described above as the second embodiment, by providing the guide layer 18 between the active layer 11 and the second cladding layer 142, the value of the product of the thickness and the refractive index of the layer other than the two-dimensional photonic-crystal layer 12 between the first cladding layer 141 and the second cladding layer 142 is made larger than the value of the product of the thickness and the refractive index of the two-dimensional photonic-crystal layer 12, but the values of the products can be set by other methods. For example, by making the sum of the thickness of the layer other than the two-dimensional photonic-crystal layer 12 between the first cladding layer 141 and the second cladding layer 142 larger than the thickness of the two-dimensional photonic-crystal layer 12, the condition of the value of the product of the thickness and the refractive index can be easily satisfied without using a material having an extremely larger refractive index (in the case of a layer other than the two-dimensional photonic-crystal layer 12) or an extremely smaller refractive index (in the case of the two-dimensional photonic-crystal layer 12) than the other layers.

In addition, by using a material having a low refractive index for the base material 121, the condition of the value of the product of the thickness and the refractive index can be easily satisfied also by making the refractive index of the two-dimensional photonic-crystal layer 12 lower than the other layers. For example, when the filling factor is 8% as in the second embodiment, the material of the base material 121 is changed from GaAs to $Al_{0.1}Ga_{0.9}As$, whereby the value of $\Gamma_{pc}$ can be reduced by about 50%.

[5] Others

In the above description, modifications (for example, using one modified refractive index region instead of one modified refractive index region pair 122, using a member having a refractive index different from that of the base material 121 instead of the hole as the modified refractive index region (pair), and the like) from the first and second embodiments have been described together with the first and second embodiments, but the present invention is not limited to these embodiments and modifications, and various further modifications are possible.

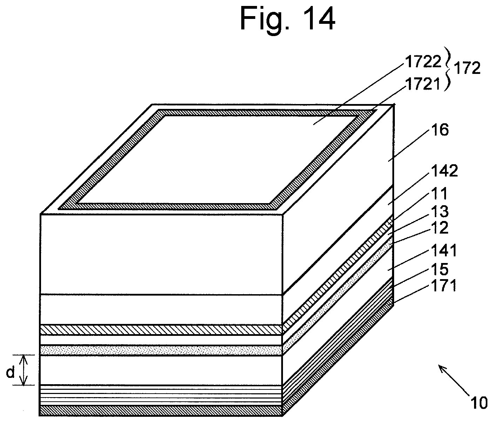

For example, in the first and second embodiments, the first electrode 171 has a circular shape, but may have another shape such as a square shape (Fig. 14). In addition, the shape of the first electrode 171 may be such that a region into which an electric current is supplied into the active layer has a shape in which one of two directions (directions of a straight line of $y = x$ and a straight line of $y = -x$ on a graph with the x direction and the y direction as coordinate axes) inclined by 45° with respect to the x direction and the y direction of the square lattice in the two-dimensional photonic-crystal layer 12 is shorter than the other. For example, in a case where there is a difference between the absolute values of the two-dimensional coupling coefficient $\kappa_{2D-}$ and $\kappa_{2D+}$ described in the section [3-1] above, the first higher order mode is likely to be localized in the direction of the straight line of $y = -x$ of the two directions. Therefore, in such a case, the laser oscillation of the first higher order mode can be more reliably suppressed by forming the region to such a shape that the direction in which the first higher order mode is localized is shorter than the other.

REFERENCE SIGNS LIST

10... Two-Dimensional Photonic-Crystal Surface-Emitting Laser
11... Active Layer
12... Two-Dimensional Photonic-Crystal Layer
121... Base Material
122... Modified Refractive Index Region Pair
1221... First Modified Refractive Index Region
1222... Second Modified Refractive Index Region
13... Spacer Layer
141... First Cladding Layer
142... Second Cladding Layer
15... Reflection Layer
16... Substrate
171... First Electrode
172... Second Electrode
1721... Frame Portion
1722... Window Portion
18... Guide Layer

**Claims**

1. A two-dimensional photonic-crystal surface-emitting laser comprising:

   a) a two-dimensional photonic-crystal layer in which modified refractive index regions having a refractive index different from a refractive index of a plate-like base material are periodically disposed in the base material;
   b) an active layer provided on one surface side of the two-dimensional photonic-crystal layer; and
   c) a reflection layer provided on another surface side of the two-dimensional photonic-crystal layer or on a side of the active layer opposite to the two-dimensional photonic-crystal layer so as to be separated from the two-dimensional photonic-crystal layer,

   **characterized in that**, a distance between surfaces of the two-dimensional photonic-crystal layer and the reflection layer facing each other is set such that a radiation coefficient difference $\Delta\alpha_v = (\alpha_{v1} - \alpha_{v0})$, which is a value obtained by subtracting a radiation coefficient $\alpha_{v0}$ of a fundamental mode having a smallest loss from a radiation coefficient $\alpha_{v1}$ of a first higher order mode having a second smallest loss among light amplified in the two-dimensional photonic-crystal layer, is 1 cm$^{-1}$ or more.

2. The two-dimensional photonic-crystal surface-emitting laser according to claim 1, wherein in the two-dimensional photonic-crystal layer,

the modified refractive index regions are arranged on a square lattice, and
the radiation coefficient difference $\Delta\alpha_v$ is represented by formula (5) using: R = Re[($\kappa_{1D}$ + $\kappa_{2D-}$) exp(-i$\theta_{PC}$)] where $\kappa_{1D}$ is a one-dimensional coupling coefficient, $\kappa_{2D-}$ is a two-dimensional coupling coefficient, and $\theta_{PC}$ is an added phase when in-plane guided light guiding an x direction in a negative direction is diffracted to in-plane guided light guiding the x direction in a positive direction via emission light; a non-Hermitian coupling coefficient $\mu$ when in-plane guided light is coupled to each other via emission light, determined by a phase difference $\theta_{ref}$ between first emission light emitted from the two-dimensional photonic-crystal layer to an opposite side of the reflection layer and second emission light emitted from the two-dimensional photonic-crystal layer to the reflection layer side and reflected by the reflection layer; and a diameter L of an inscribed circle in a range in which light emission occurs due to supplying an electric current into the active layer

[Mathematical formula 5]

$$\Delta\alpha_v = \frac{\mu}{(\mu^2 + R^2)}\left(\frac{3\pi^2}{2L^2}\right).$$

3. The two-dimensional photonic-crystal surface-emitting laser according to claim 2, wherein a value of a diameter L of the inscribed circle is 1 mm or more.

4. The two-dimensional photonic-crystal surface-emitting laser according to claim 2 or 3, wherein an absolute value of the phase difference $\theta_{ref}$ is 90° or more and less than 180°.

5. The two-dimensional photonic-crystal surface-emitting laser according to any one of claims 1 to 4, wherein each of the modified refractive index regions is made of a modified refractive index region pair in which a first modified refractive index region and a second modified refractive index region having different planar areas are disposed apart from each other.

6. The two-dimensional photonic-crystal surface-emitting laser according to any one of claims 1 to 5, further comprising an electrode configured to supply an electric current into the active layer,

wherein

the modified refractive index regions are arranged on a square lattice having a predetermined period, and
a shape of the electrode includes such a region into which an electric current is supplied into the active layer that any one of two directions inclined by 45° with respect to two directions in which lattice points of the square lattice are disposed in the period is shorter than the other.

7. The two-dimensional photonic-crystal surface-emitting laser according to any one of claims 1 to 6, further comprising a first cladding layer formed of a p-type semiconductor or an n-type semiconductor and provided between the two-dimensional photonic-crystal layer and the reflection layer, and a second cladding layer formed of a semiconductor having carriers whose polarity is opposite to that of the first cladding layer and provided on a side opposite to the reflection layer side as viewed from the two-dimensional photonic-crystal layer, the first cladding layer and the second cladding layer being provided so as to sandwich the two-dimensional photonic crystal layer and the active layer,
wherein a product of a thickness and a refractive index of a layer other than the two-dimensional photonic-crystal layer between the first cladding layer and the second cladding layer is larger than a product of a thickness and a refractive index of the two-dimensional photonic-crystal layer.

8. The two-dimensional photonic-crystal surface-emitting laser according to claim 7, wherein a sum of thicknesses of layers other than the two-dimensional photonic-crystal layer between the first cladding layer and the second cladding layer is larger than a thickness of the two-dimensional photonic-crystal layer.

9. The two-dimensional photonic-crystal surface-emitting laser according to claim 7 or 8, wherein a refractive index of the two-dimensional photonic-crystal layer is lower than a refractive index of a layer other than the two-dimensional photonic-crystal layer between the first cladding layer and the second cladding layer.

10. The two-dimensional photonic-crystal surface-emitting laser according to any one of claims 7 to 9, further comprising a guide layer between the first cladding layer and the second cladding layer on a side opposite to the two-dimensional photonic crystal layer as viewed from the active layer.

**Patentansprüche**

1.  Ein oberflächenemittierender Laser mit einem zweidimensionalen photonischen Kristall, umfassend:

    a) eine zweidimensionale photonische Kristalllage, in welcher modifizierte Brechungsindexbereiche, welche einen Brechungsindex aufweisen, welcher von einem Brechungsindex eines plattenartigen Basismaterials verschieden ist, in dem Basismaterial periodisch angeordnet sind;
    b) eine aktive Lage, welche auf einer Oberflächenseite der zweidimensionalen photonischen Kristalllage bereitgestellt ist; und
    c) eine Reflexionslage, welche auf einer anderen Oberflächenseite der zweidimensionalen photonischen Kristalllage oder auf einer der zweidimensionalen photonischen Kristalllage gegenüberliegenden Seite der aktiven Lage bereitgestellt ist, derart, dass sie von der zweidimensionalen photonischen Kristalllage getrennt ist,

    **dadurch gekennzeichnet, dass** eine Distanz zwischen Oberflächen der zweidimensionalen photonischen Kristalllage und der Reflexionslage, welche einander gegenüberliegen, derart gesetzt ist, dass eine Strahlungskoeffizientendifferenz $\Delta\alpha_v = (\alpha_{v1} - \alpha_{v0})$, bei der es sich um einen Wert handelt, welcher erhalten wird durch Subtraktion eines Strahlungskoeffizienten $\alpha_{v0}$ einer Grundmode mit dem geringsten Verlust von einem Strahlungskoeffizienten $\alpha_{v1}$ einer ersten Mode höherer Ordnung mit dem zweitgeringsten Verlust aus dem in der zweidimensionalen photonischen Kristalllage verstärkten Licht, 1 cm$^{-1}$ oder mehr beträgt.

2.  Der oberflächenemittierende Laser mit einem zweidimensionalen photonischen Kristall nach Anspruch 1, wobei in der zweidimensionalen photonischen Kristalllage

    die modifizierten Brechungsindexbereiche auf einem quadratischen Gitter angeordnet sind und
    die Strahlungskoeffizientendifferenz $\Delta\alpha_v$ repräsentiert ist durch eine Formel (5) mit R = Re[$(\kappa_{1D} + \kappa_{2D-})$exp($-i\theta_{PC}$)], worin $\kappa_{1D}$ ein eindimensionaler Kopplungskoeffizient ist, $\kappa_{2D-}$ ein zweidimensionaler Kopplungskoeffizient ist und $\theta_{PC}$ eine addierte Phase ist, wenn in der Ebene geführtes Licht, welches eine x-Richtung in einer negativen Richtung führt, zu in der Ebene geführtem Licht, welches die x-Richtung in einer positiven Richtung führt, via Emissionslicht gebeugt wird; einem nichthermiteschen Kopplungskoeffizienten $\mu$, wenn in der Ebene geführtes Licht via Emissionslicht miteinander gekoppelt wird, be-

stimmt durch eine Phasendifferenz $\theta_{ref}$ zwischen einem erstem Emissionslicht, welches von der zweidimensionalen photonischen Kristalllage zu einer gegenüberliegenden Seite der Reflexionslage emittiert wird, und einem zweitem Emissionslicht, das von der zweidimensionalen photonischen Kristalllage zu der Seite der Reflexionslage emittiert und von der Reflexionslage reflektiert wird; und einem Durchmesser L eines Inkreises in einem Bereich, in dem Lichtemission aufgrund Zuführung eines elektrischen Stroms in die aktive Lage hinein auftritt

[Mathematische Formel 5]

$$\Delta\alpha_v = \frac{\mu}{(\mu^2 + R^2)}\left(\frac{3\pi^2}{2L^2}\right).$$

3.  Der oberflächenemittierende Laser mit einem zweidimensionalen photonischen Kristall nach Anspruch 2, wobei ein Wert eines Durchmessers L des Inkreises 1 mm oder mehr beträgt.

4.  Der oberflächenemittierende Laser mit einem zweidimensionalen photonischen Kristall nach Anspruch 2 oder 3, wobei ein Absolutwert der Phasendifferenz $\theta_{ref}$ 90° oder mehr und weniger als 180° beträgt.

5.  Der oberflächenemittierende Laser mit einem zweidimensionalen photonischen Kristall nach einem der Ansprüche 1 bis 4, wobei jeder der modifizierten Brechungsindexbereiche von einem modifizierten Brechungsindexbereichspaar gebildet ist, in dem ein erster modifizierter Brechungsindexbereich und ein zweiter modifizierter Brechungsindexbereich, welche unterschiedliche planare Flächen aufweisen, getrennt voneinander angeordnet sind.

6.  Der oberflächenemittierende Laser mit einem zweidimensionalen photonischen Kristall nach einem der Ansprüche 1 bis 5, ferner umfassend:

    eine Elektrode, welche dazu ausgebildet ist, einen elektrischen Strom in die aktive Lage einzuspeisen,
    wobei
    die modifizierten Brechungsindexbereiche auf einem quadratischen Gitter mit einer vorbestimmten Periode angeordnet sind, und
    eine Gestalt der Elektrode einen solchen Bereich, in den ein elektrischer Strom in die aktive Lage eingespeist wird, umfasst, dass irgendeine von zwei Richtungen, welche um 45° in Bezug auf zwei Richtungen geneigt sind, in denen Gitterpunkte des quadratischen Gitters in der Periode angeordnet sind, kürzer ist als die andere.

7. Der oberflächenemittierende Laser mit einem zweidimensionalen photonischen Kristall nach einem der Ansprüche 1 bis 6, ferner umfassend eine erste Cladding-Lage, welche von einem p-Typ-Halbleiter oder einem n-Typ-Halbleiter gebildet ist und zwischen der zweidimensionalen photonischen Kristalllage und der Reflexionslage bereitgestellt ist, und eine zweite Cladding-Lage, welche von einem Halbleiter gebildet ist, welcher Träger aufweist, deren Polarität derjenigen der ersten Cladding-Lage entgegengesetzt ist, und welche auf einer Seite bereitgestellt ist, die, von der zweidimensionalen photonischen Kristalllage aus gesehen, auf einer der Seite der Reflexionslage gegenüberliegenden Seite bereitgestellt ist, wobei die erste Cladding-Lage und die zweite Cladding-Lage derart bereitgestellt sind, dass sie die zweidimensionale photonische Kristalllage und die aktive Lage sandwichartig einschließen, wobei ein Produkt aus einer Dicke und einem Brechungsindex einer Lage, welche von der zweidimensionalen photonischen Kristalllage zwischen der ersten Cladding-Lage und der zweiten Cladding-Lage verschieden ist, größer ist als ein Produkt aus einer Dicke und einem Brechungsindex der zweidimensionalen photonischen Kristalllage.

8. Der oberflächenemittierende Laser mit einem zweidimensionalen photonischen Kristall nach Anspruch 7, wobei eine Summe von Dicken von Lagen, welche von der zweidimensionalen photonischen Kristalllage zwischen der ersten Cladding-Lage und der zweiten Cladding-Lage verschieden sind, größer ist als eine Dicke der zweidimensionalen photonischen Kristalllage.

9. Der oberflächenemittierende Laser mit einem zweidimensionalen photonischen Kristall nach Anspruch 7 oder 8, wobei ein Brechungsindex der zweidimensionalen photonischen Kristalllage niedriger ist als ein Brechungsindex einer Lage, welche von der zweidimensionalen photonischen Kristalllage zwischen der ersten Cladding-Lage und der zweiten Cladding-Lage verschieden ist.

10. Der oberflächenemittierende Laser mit einem zweidimensionalen photonischen Kristall nach einem der Ansprüche 7 bis 9, ferner umfassend eine Führungslage zwischen der ersten Cladding-Lage und der zweiten Cladding-Lage auf einer Seite, welche, von der aktiven Lage aus gesehen, der zweidimensionalen photonischen Kristallllage gegenüberliegt.

**Revendications**

1. Laser à émission de surface à cristal photonique bidimensionnel comprenant :

   a) une couche de cristal photonique bidimensionnel dans laquelle des régions d'indice de réfraction modifié présentant un indice de réfraction différent d'un indice de réfraction d'un matériau de base en plaque sont périodiquement disposées dans le matériau de base ;
   b) une couche active prévue sur un côté de surface de la couche de cristal photonique bidimensionnel ; et
   c) une couche de réflexion prévue sur un autre côté de surface de la couche de cristal photonique bidimensionnel ou sur un côté de la couche active opposé à la couche de cristal photonique bidimensionnel de manière à être séparée de la couche de cristal photonique bidimensionnel,

   **caractérisé en ce qu'**une distance entre des surfaces de la couche de cristal photonique bidimensionnel et la couche de réflexion se faisant face est réglée de sorte qu'une différence de coefficient de rayonnement $\Delta\alpha_v = (\alpha_{v1} - \alpha_{v0})$, qui est une valeur obtenue en soustrayant un coefficient de rayonnement $\alpha_{v0}$ d'un mode fondamental présentant une perte la plus faible d'un coefficient de rayonnement $\alpha_{v1}$ d'un premier mode d'ordre supérieur présentant une seconde perte la plus faible parmi les lumières amplifiées dans la couche de cristal photonique bidimensionnel, est de 1 cm$^{-1}$ ou plus.

2. Laser à émission de surface à cristal photonique bidimensionnel selon la revendication 1, dans lequel dans la couche de cristal photonique bidimensionnel,

   les régions d'indice de réfraction modifié sont agencées sur une grille carrée, et
   la différence de coefficient de rayonnement $\Delta\alpha_v$ est représentée par la formule (5) utilisant : R = Re[$(k_{1D} + k_{2D-})$exp($-i\theta_{PC}$)] où $k_{1D}$ est un coefficient de couplage unidimensionnel, $k_{2D-}$ est un coefficient de couplage bidimensionnel, et $\theta_{PC}$ est une phase ajoutée lorsque la lumière guidée en plan guidant une direction x dans une direction négative est diffractée en lumière guidée en plan guidant la direction x dans une direction positive via une lumière d'émission ; un coefficient de couplage non hermitien $\mu$ lorsque les lumières guidées en plan sont couplées l'une à l'autre via la lumière d'émission, déterminé par une différence de phase $\theta_{réf}$ entre la première lumière d'émission émise de la couche de cristal photonique bidimensionnel vers un côté opposé de la couche de réflexion et la seconde lumière d'émission émise de la couche de cristal photonique bidimensionnel vers le côté de la couche de réflexion et réfléchie par la couche de réflexion ; et un diamètre L d'un cercle inscrit dans une plage dans laquelle une émission de lumière se produit en raison de l'alimentation d'un courant électrique dans la couche active

[Formule mathématique 5]

$$\Delta\alpha_v = \frac{\mu}{(\mu^2 + R^2)}\left(\frac{3\pi^2}{2L^2}\right)$$

3. Laser à émission de surface à cristal photonique bidimensionnel selon la revendication 2, dans lequel une valeur d'un diamètre L du cercle inscrit est de 1 mm ou plus.

4. Laser à émission de surface à cristal photonique bidimensionnel selon la revendication 2 ou 3, dans lequel une valeur absolue de la différence de phase $\theta_{réf}$ est de 90° ou plus et inférieure à 180°.

5. Laser à émission de surface à cristal photonique bidimensionnel selon l'une quelconque des revendications 1 à 4, dans lequel chacune des régions d'indice de réfraction modifié est constituée d'une paire de régions d'indice de réfraction modifié dans laquelle une première région d'indice de réfraction modifié et une seconde région d'indice de réfraction modifié présentant des zones planes différentes sont disposées à l'écart l'une de l'autre.

6. Laser à émission de surface à cristal photonique bidimensionnel selon l'une quelconque des revendications 1 à 5, comprenant en outre une électrode configurée pour fournir un courant électrique dans la couche active,
dans lequel

les régions d'indice de réfraction modifié sont agencées sur une grille carrée présentant une période prédéterminée, et
une forme de l'électrode comporte une région dans laquelle un courant électrique est fourni dans la couche active de sorte que l'une quelconque de deux directions inclinées de 45° par rapport à deux directions dans lesquelles des points de grille de la grille carrée sont disposés dans la période soit plus courte que l'autre.

7. Laser à émission de surface à cristal photonique bidimensionnel selon l'une quelconque des revendications 1 à 6, comprenant en outre une première couche de revêtement constituée d'un semi-conducteur de type p ou d'un semi-conducteur de type n et prévue entre la couche de cristal photonique bidimensionnel et la couche de réflexion, et une seconde couche de revêtement constituée d'un semi-conducteur présentant des charges dont la polarité est opposée à celle de la première couche de revêtement et prévue sur un côté opposé au côté de la couche de réflexion en vue de la couche de cristal photonique bidimensionnelle, la première couche de revêtement et la seconde couche de revêtement étant prévues de manière à prendre en sandwich la couche de cristal photonique bidimensionnelle et la couche active,
dans lequel un produit d'une épaisseur et d'un indice de réfraction d'une couche autre que la couche de cristal photonique bidimensionnelle entre la première couche de revêtement et la seconde couche de revêtement est plus grand qu'un produit d'une épaisseur et d'un indice de réfraction de la couche de cristal photonique bidimensionnelle.

8. Laser à émission de surface à cristal photonique bidimensionnel selon la revendication 7, dans lequel une somme d'épaisseurs de couches autres que la couche de cristal photonique bidimensionnel entre la première couche de revêtement et la seconde couche de revêtement est supérieure à une épaisseur de la couche de cristal photonique bidimensionnel.

9. Laser à émission de surface à cristal photonique bidimensionnel selon la revendication 7 ou 8, dans lequel un indice de réfraction de la couche de cristal photonique bidimensionnel est inférieur à un indice de réfraction d'une couche autre que la couche de cristal photonique bidimensionnel entre la première couche de revêtement et la seconde couche de revêtement.

10. Laser à émission de surface à cristal photonique bidimensionnel selon l'une quelconque des revendications 7 à 9, comprenant en outre une couche de guidage entre la première couche de revêtement et la seconde couche de revêtement sur un côté opposé à la couche de cristal photonique bidimensionnel en vue de la couche active.

# Fig. 1A

# Fig. 1B

## Fig. 2

## Fig. 3A

δa = 0.264a TO 0.280a
1222
DIAMETER (67.3-2x) nm
MINOR AXIS DIAMETER (52.6+2x) nm
MAJOR AXIS DIAMETER 124.8 nm
2x = 3.0 TO 6.1 nm
1221
122

## Fig. 3B

# Fig. 4

# Fig. 5A

# Fig. 5B

## Fig. 6

## Fig. 7

# Fig. 8

# Fig. 9

## Fig. 10

## Fig. 11

# Fig. 12

# Fig. 13

# Fig. 14

**REFERENCES CITED IN THE DESCRIPTION**

**Patent documents cited in the description**

- JP 2008243962 A
- US 2019067907 A1, NODA SUSUMU
- WO 2016031965 A1
- US 2019013647 A1, HIGUCHI AKIRA
- US 2016020581 A1, HIROSE KAZUYOSHI